# EUROPÄISCHE PATENTSCHRIFT

(11) **EP 3 180 859 B1**
(45) Veröffentlichungstag und Bekanntmachung des Hinweises auf die Patenterteilung: **10.04.2019**
(21) Anmeldenummer: 15750694.0
(22) Anmeldetag: 10.08.2015
(51) Int. Cl.: H03K 17/955, H03K 9/08

(54) **SCHALTUNG UND VERFAHREN ZUM AUSWERTEN VON MESSSIGNALEN SOWIE SENSORSYSTEM ZUM KAPAZITIVEN ERFASSEN VON HINDERNISSEN**
CIRCUIT AND METHOD FOR EVALUATING MEASUREMENT SIGNALS AND SENSOR SYSTEM FOR CAPACITIVELY DETECTING OBSTACLES
CIRCUIT ET PROCÉDÉ D'INTERPRÉTATION DES SIGNAUX DE MESURE AINSI QUE SYSTÈME DE CAPTEUR POUR LA DÉTECTION CAPACITIVE D'OBSTACLES

(30) Priorität: 15.08.2014 DE 102014216246
(43) Veröffentlichungstag der Anmeldung: 21.06.2017
(73) Patentinhaber: Mayser GmbH & Co. KG, 89073 Ulm (DE)
(72) Erfinder: WIEST, Thomas, 88416 Ochsenhausen (DE); KELSCH, Manuel, 89073 Ulm (DE)
(74) Vertreter: Patentanwälte Ruff, Wilhelm, Beier, Dauster & Partner mbB
(86) Internationale Anmeldenummer: PCT/EP2015/068368
(87) Internationale Veröffentlichungsnummer: WO 2016/023862

(56) Entgegenhaltungen:
- DE-A1-102008 047 434
- DE-B3-102012 217 086
- US-A1- 2002 154 039

## Beschreibung

Die Erfindung betrifft eine Schaltung und ein Verfahren zum Auswerten von Messsignalen.

Die Erfindung betrifft auch ein Sensorsystem zur kapazitiven Erfassung von Hindernissen mit einem kapazitiven Sensor und einer erfindungsgemäßen Schaltung.

Aus der US-Patentschrift 8,334,623 B2 ist ein Schaltleistensystem zur kapazitiven Erfassung von Hindernissen bekannt. Die dort in Fig. 14 gezeigte Ausführungsform weist eine Brückenschaltung auf, wobei die beiden Leiter eines Schaltleistenprofils mit jeweils einem Ende des Brückenzweiges verbunden sind. Eine Auswertung des Schaltleistensystems erfolgt aber dadurch, dass eine Spannung an dem in Erfassungsrichtung vorne liegenden Leiter mit einem von einer Veränderung der Kapazität zwischen den beiden Leitern und einem Hindernis unbeeinflussten Referenzsignal verglichen wird.

Aus der deutschen Offenlegungsschrift DE 10 2008 005 783 A1 ist ein Sensorsystem zur kapazitiven Erfassung von Hindernissen bekannt, bei dem ein Ansteuersignal in zwei leitfähige Elemente eines kapazitiven Sensors eingespeist wird. Das invertierte Ansteuersignal wird mit dem Signal des in Erfassungsrichtung vorderen Leiters überlagert und das Überlagerungssignal wird zu null geregelt. Ist im Erfassungsbereich ein Hindernis vorhanden, kann dieses mittels der dann erforderlichen Nachregelung detektiert werden.

Aus der deutschen Offenlegungsschrift DE 10 2008 047 434 A1 ist eine Schaltung zum Auswerten von Messsignalen wenigstens eines Sensors mit einer Steuerschaltung bekannt, wobei mittels eines Ansteuerabschnitts der Steuerschaltung ein Ansteuersignal mit einer ersten Frequenz erzeugt wird, wobei der wenigstens eine Sensor mit dem Ansteuersignal beaufschlagt wird, wobei eine Auswerteelektronik zum Erzeugen eines Auswertesignals ausgehend von einem mit dem Sensor erzeugten Messsignal vorgesehen ist, wobei die Auswerteelektronik Mittel zum Erzeugen eines Gegensignals mit der ersten Frequenz sowie veränderbarer Phasenlage und Mittel zum Überlagern des Gegensignals und des Auswertesignals aufweist und wobei das sich aus dem Überlagern des Gegensignals und des Auswertesignals ergebende Signal der Auswerteelektronik zugeführt wird.

Aus der deutschen Patentschrift DE 10 2012 217 086 B3 ist ein kapazitiver Sensor für die Erfassung von Hindernissen im Bereich einer bewegbaren Türe bekannt. Eine Schaltung zum Auswerten der Messsignale des kapazitiven Sensors arbeitet so, dass ein erster Leiter des Sensors mit einem Shield-Signal beaufschlagt wird und ein zweiter Leiter des Sensors als Messelektrode verwendet wird. Es wird ein Messsignal mit einem Referenzsignal verglichen. Im abgeglichenen Zustand löschen sich das Referenzsignal und das Messsignal aus, so dass eine sehr hohe Verstärkung des Differenzsignals gewählt werden kann. Das Ausgangssignal des Verstärkers wird einem Synchrondemodulator zugeführt.

Mit der Erfindung sollen eine verbesserte Schaltung und ein verbessertes Verfahren zum Auswerten von Messsignalen um ein verbessertes Sensorsystem bereitgestellt werden.

Erfindungsgemäß ist hierzu eine Schaltung zum Auswerten von Messsignalen wenigstens eines Sensors mit den Merkmalen von Anspruch 1 vorgesehen. Die Schaltung ist mit einer Steuerschaltung und einer Auswerteelektronik versehen, wobei mittels eines Ansteuerabschnitts der Steuerschaltung ein Ansteuersignal mit einer ersten Frequenz erzeugt wird, wobei der wenigstens eine Sensor mit dem Ansteuersignal beaufschlagt wird, wobei die Auswerteelektronik zum Erzeugen eines Auswertesignals ausgehend von einem mit dem Sensor erzeugten Messsignal vorgesehen ist, wobei die Auswerteelektronik Mittel zum Erzeugen eines Gegensignals mit der ersten Frequenz sowie veränderbarer Phasenlage und Mittel zum Überlagern des Gegensignals und des Auswertesignals ausweist und wobei das sich aus dem Überlagern des Gegensignals und des Auswertesignals ergebende Signal einem Synchrondemodulator der Auswerteelektronik zugeführt wird.

Indem ein Gegensignal mit der gleichen Frequenz wie das Ansteuersignal erzeugt und dem Auswertesignal überlagert wird, kann eine sehr empfindliche Detektion von Hindernissen erfolgen, vor allem aber kann das System im Ruhezustand, also ohne Vorhandensein eines Hindernisses, sehr zuverlässig und schnell abgestimmt werden. Denn durch die veränderbare Phasenlage des Gegensignals können Phasenverschiebungen des Auswertesignals, die durch die Einbauverhältnisse auch ohne Vorhandensein eines Hindernisses auftreten, in sehr einfacher Weise ausgeglichen werden. Der Abgleich des Sensorsystems in einem Abgleichbetrieb kann sogar voll automatisch erfolgen, was die erfindungsgemäße Schaltung in besonderer Weise für den Serieneinsatz geeignet macht, beispielsweise zur Erfassung von Hindernissen im Bereich einer Türe oder Klappe eines Kraftfahrzeugs. Durch die Überlagerung des Gegensignals und des Auswertesignals und das Zuführen des sich aus der Überlagerung ergebenden Signals an einen Synchrondemodulator ergeben sich weitere Vorteile in Bezug auf die Empfindlichkeit des Systems in einem Detektionsbetrieb, aber auch in Bezug auf die einfache Initialisierung und Abgleichung des Systems in einem Abgleichbetrieb, also ohne Vorhandensein eines Hindernisses.

In Weiterbildung der Erfindung sind die Mittel zum Erzeugen des Gegensignals zum Verändern einer Amplitude des Gegensignals ausgebildet.

Auf diese Weise kann in einem Abgleichbetrieb eine besonders einfache und schnelle Abstimmung des Sensorsystems auf die konkret vorhandenen Einbauverhältnisse erfolgen.

In Weiterbildung der Erfindung arbeiten die Mittel zum Erzeugen des Gegensignals in Abhängigkeit eines Ausgangssignals des Synchrondemodulators.

Am Ausgang des Synchrondemodulators liegt im abgeglichenen Zustand des Systems, also beispielsweise ohne Vorhandensein eines Hindernisses, ein Signal mit dem Wert null oder eine konstante Gleichspannung mit einem vordefinierten Wert an. Ist ein gewünschter Abgleich des Systems noch nicht erreicht, so kann in sehr einfacher Weise das Ausgangssignal des Synchrondemodulators als Eingangsgröße verwendet werden, um das Gegensignal in Bezug auf Phasenlage und/oder Amplitude zu verändern und dadurch einen Abgleich zu erzielen.

In Weiterbildung der Erfindung wird eine Phasenverschiebung und/oder eine Amplitude des Gegensignals, insbesondere zum Detektieren eines Hindernisses ausgewertet.

Wird beispielsweise auch während des Detektionsbetriebs das Ausgangssignal des Synchrondemodulators auf einem konstanten Wert gehalten, so kann die hierzu erforderliche Phasenverschiebung und/oder Amplitudenveränderung des Gegensignals beispielsweise zum Detektieren eines Hindernisses verwendet werden.

In Weiterbildung der Erfindung wird ein Ausgangssignal des Synchrondemodulators insbesondere zum Detektieren eines Hindernisses ausgewertet.

Das Ausgangssignal des Synchrondemodulators ermöglicht eine zuverlässige Aussage darüber, ob sich das Messsignal verändert hat und beispielsweise ein Hindernis im Erfassungsbereich des Sensors vorhanden ist.

In Weiterbildung der Erfindung weist die Auswerteelektronik einen Regelkreis auf, wobei eine Phasenverschiebung des Gegensignals zum Regeln eines Ausgangssignals des Synchrondemodulators verwendet wird.

Mittels einer Phasenverschiebung des Gegensignals kann das Ausgangssignal des Synchrondemodulators auf einen konstanten Wert geregelt werden. Die hierzu erforderliche Phasenverschiebung des Gegensignals kann dann beispielsweise zum Detektieren eines Hindernisses verwendet werden.

Die Erfindung betrifft auch ein Verfahren zum Auswerten von Messsignalen mit den Merkmalen von Anspruch 7. Das Verfahren zum Auswerten von Messsignalen, die von wenigstens einem Sensor erzeugt werden, wird mit einer erfindungsgemäßen Schaltung, mit den Schritten Beaufschlagen des Sensors mit einem Ansteuersignal mit einer ersten Frequenz, Erzeugen eines Gegensignals mit der ersten Frequenz sowie veränderbarer Phasenlage, Erzeugen eines Auswertesignals ausgehend von einem mit dem Sensor erzeugten Messsignal, Überlagern des Auswertesignals und des Gegensignals und Zuführen des sich aus der Überlagerung ergebenden Signals zu einem Synchrondemodulator durchgeführt.

Gemäß der Erfindung erfolgt in einem Abgleichbetrieb ein automatisches Abgleichen der Schaltung mittels Einstellen einer Phasenverschiebung des Gegensignals in Abhängigkeit eines Ausgangssignals des Synchrondemodulators.

Auf diese Weise kann die erfindungsgemäße Schaltung bzw. ein mit der Schaltung versehenes Sensorsystem auf die jeweils vorhandenen Einbauverhältnisse abgestimmt werden. Dies ist deshalb von Bedeutung, da auch dann, wenn die Schaltung bzw. das Sensorsystem im Rahmen einer Serienfertigung an einer Tür oder Klappe eines Kraftfahrzeugs eingebaut wird, die Einbauverhältnisse niemals exakt gleich sind. Ein automatischer Abgleich des Sensorsystems ist dann äußerst vorteilhaft, um die geringfügig unterschiedlichen Einbauverhältnisse nicht im Detektionsbetrieb berücksichtigen zu müssen. Mittels Einstellen einer Phasenverschiebung des Gegensignals kann ein solcher Abgleich auf die jeweils vorhandenen Einbauverhältnisse schnell und zuverlässig erfolgen.

Gemäß der Erfindung wird in einem Abgleichbetrieb eine Phasenverschiebung des Gegensignals und ein Takt des Synchrondemodulators so eingestellt, dass das Auswertesignal, das Gegensignal und der Takt des Synchrondemodulators phasengleich sind.

In einem ersten Schritt im Abgleichbetrieb wird eine solche phasengleiche Einstellung vorgenommen.

In Weiterbildung der Erfindung wird in einem Abgleichbetrieb eine Amplitude des Gegensignals so eingestellt, dass das Ausgangssignal des Synchrondemodulators einen Wert null oder einen vordefinierten Wert aufweist.

Im Anschluss an das phasengleiche Einstellen des Auswertesignals, des Gegensignals und des Synchrondemodulators wird dann die Amplitude des Gegensignals so eingestellt, dass das Ausgangssignal des Synchrondemodulators einen vordefinierten Wert aufweist. Auf diese Weise können die Einbauverhältnisse ausgeglichen werden bzw. kann die Schaltung bzw. das Sensorsystem schnell und zuverlässig auf die jeweils vorhandenen Einbauverhältnisse abgestimmt werden.

In Weiterbildung der Erfindung erfolgt in einem Detektionsbetrieb ein Auswerten einer Phasenverschiebung des Gegensignals, insbesondere zum Detektieren eines Hindernisses.

In Weiterbildung der Erfindung erfolgt in einem Detektionsbetrieb ein Auswerten eines Ausgangssignals des Synchrongenerators, insbesondere zum Detektieren eines Hindernisses.

In Weiterbildung der Erfindung erfolgt in einem Detektionsbetrieb eine Regelung eines Ausgangssignals des Synchrongenerators auf einen Wert null oder einen vordefinierten Wert.

In Weiterbildung der Erfindung ist bei der Regelung als Stellgröße eine Phasenverschiebung und/oder eine Amplitude des Gegensignals vorgesehen.

Die Erfindung betrifft auch ein Sensorsystem zum kapazitiven Erfassen von Hindernissen mit wenigstens einem kapazitiven Sensor und einer erfindungsgemäßen Schaltung.

Weitere Merkmale und Vorteile der Erfindung ergeben sich aus den Ansprüchen und der folgenden Beschreibung bevorzugter Ausführungsformen der Erfindung im Zusammenhang mit der Beschreibung. Einzelmerkmale der unterschiedlichen, dargestellten und beschriebenen Ausführungsformen können dabei in beliebiger Weise miteinander kombiniert werden, ohne den Rahmen der Erfindung zu überschreiten. In den Zeichnungen zeigen:
- Fig. 1: eine schematische Darstellung eines erfindungsgemäßen Sensorsystems gemäß einer ersten Ausführungsform,
- Fig. 2: eine schematische Darstellung eines erfindungsgemäßen Sensorsystems gemäß einer zweiten Ausführungsform und
- Fig. 3: eine schematische Darstellung eines erfindungsgemäßen Sensorsystems gemäß einer dritten Ausführungsform.

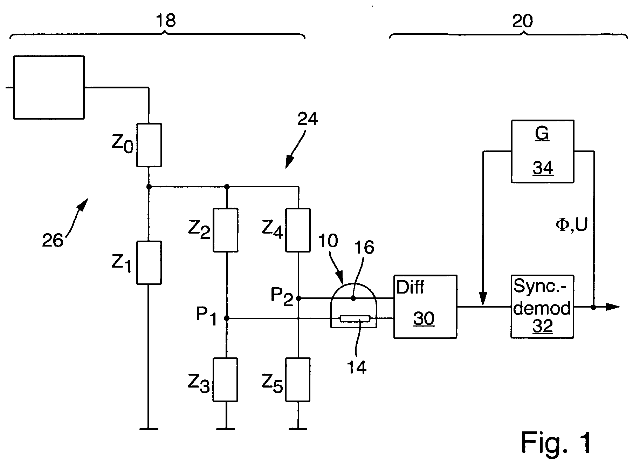

Die Darstellung der Fig. 1 zeigt schematisch ein erfindungsgemäßes Sensorsystem gemäß einer ersten Ausführungsform der Erfindung. Die beiden Leiter 14, 16 des Sensors 10 bzw. der Schaltleiste sind einerseits mit dem ersten Ende P1 und dem zweiten Ende P2 des Brückenzweiges und andererseits mit den Eingängen eines Differenzierers 30 verbunden. Das Ausgangssignal des Differenzierers 30 wird wiederum auf einem Synchrondemodulator 32 geführt. Das Ausgangssignal des Synchrondemodulators 32 dient unter anderem zur Erzeugung eines Gegensignals G mit einem Element 34, das dann wiederum zwischen dem Ausgang des Differenzierers 30 und dem Eingang des Synchrondemodulators 32 mit dem Ausgangssignal des Differenzierers 30 überlagert wird. Das Gegensignal G kann bezüglich seiner Phase und Amplitude eingestellt werden, so dass sich im abgeglichenen Zustand des Systems, aber ohne Vorhandensein eines Hindernisses, am Eingang des Synchrondemodulators 32 ein Nullsignal oder ein Signal mit einem konstanten vordefinierten Wert ergibt. Die Veränderung des Gegensignals kann nun lediglich beim anfänglichen Abgleichen des Systems erfolgen, also beispielsweise nach dem Einbau des Sensorsystems in ein Kraftfahrzeug. Dieses Abgleichen kann dabei automatisch in der Weise erfolgen, dass das Gegensignal G solange verändert wird, bis am Eingang des Synchrondemodulators 32 ein Nullsignal oder ein Signal mit einem vordefinierten Wert vorliegt. Versuche haben gezeigt, dass die Abstimmung eines erfindungsgemäßen Sensorsystems auf diese Weise schnell, präzise und unproblematisch erfolgen kann.

Wird dann ein Hindernis an den Sensor 10 angenähert, verändert sich das Ausgangssignal des Differenzierers 30 und somit auch das Eingangssignal und das Ausgangssignal des Synchrondemodulators 32 und das Hindernis kann durch diese Signalabweichung detektiert werden.

Es ist darüber hinaus auch möglich, durch Überlagerung des Ausgangssignals des Differenzierers 30 mit dem Gegensignal G auch während des laufenden Betriebs das Signal am Eingang des Synchrondemodulators 32 auf Null zu regeln. Bei einer solchen Regelung des Eingangssignals des Synchrondemodulators 32 auf Null kann das Signal zwischen dem Differenzierer 30 und dem Synchrondemodulator 32 sehr hoch verstärkt werden, so dass sich auch eine sehr hohe Auflösung des erfindungsgemäßen Sensorsystems ergibt. Zur Auswertung einer Annäherung eines Hindernisses kann dann entweder eine Gleichspannung am Ausgang des Synchrondemodulators 32 oder auch die Amplitude und Phasenlage des Gegensignals G verwendet werden. Über die Kenntnis der Phasenlage des Gegensignals sind weitere Aussagen über das zu erfassende Hindernis möglich.

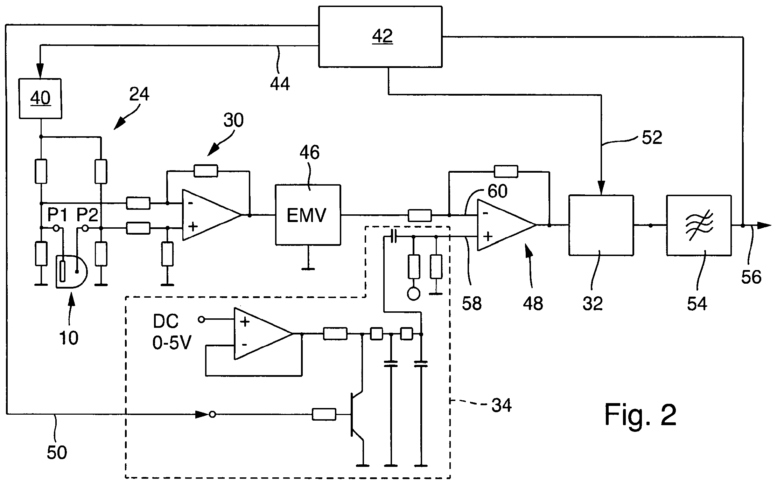

Die Darstellung der Fig. 2 zeigt schematisch ein erfindungsgemäßes Sensorsystem gemäß einer weiteren Ausführungsform der Erfindung. Die beiden Leiter des Sensors 10 sind in gleicher Weise wie bei der ersten Ausführungsform mit den beiden Enden P1 und P2 der Brückenschaltung 24 verbunden, die im Übrigen auch identisch zu der Ausführungsform der Fig. 1 aufgebaut ist und daher nicht erneut erläutert wird. Ein Ansteuersignal wird mittels einer Schaltung 40 erzeugt, die beispielsweise einen Schwingkreis aufweist. Der Schaltung 40 wird dabei von einer Steuerelektronik 42 ein erster Takt 44 zugeführt. Die Steuerelektronik 42 kann beispielsweise einen Mikroprozessor aufweisen und stellt, wie noch erläutert werden wird, frequenzgleiche aber gegebenenfalls phasenverschobene Taktsignale zur Verfügung.

Die Signale an den beiden Enden P1, P2 des Brückenzweiges werden, wie bei der Ausführungsform der Fig. 1, einem Differenzierer 30 zugeführt, der nicht erneut erläutert wird. Das Ausgangssignal des Differenzierers wird einer Schaltung 46 zugeführt, die die Einflüsse von elektromagnetischen Störungen mindert, die aber nicht weiter erläutert wird und in konventioneller Weise aufgebaut ist. Ausgehend von der Schaltung 46 wird das Signal einem weiteren Differenzverstärker 48 zugeführt. Der andere Eingang des Differenzverstärkers 48 wird mittels einer Schaltung 34 beaufschlagt, die ein Gegensignal erzeugt. Diese Schaltung 34 erhält von der Steuerelektronik 42 einen zweiten Takt 50. Der erste Takt 44, der die Frequenz des der Schaltleiste 10 zugeführten Ansteuersignals bestimmt und die Frequenz des zweiten Takts 50 für die Erzeugung des Gegensignals sind dabei frequenzgleich, gegebenenfalls aber phasenverschoben. Vorteilhafterweise sind der erste Takt 44 und der zweite Takt 50 als Sinussignal ausgebildet.

Ausgehend von dem Differenzverstärker 48 wird das sich dann ergebende Signal dem Synchrondemodulator 32 zugeführt. Ein Abtastverhalten des Synchrondemodulators 32 wird über einen dritten Takt 52 gesteuert, der ebenfalls von der Steuerelektronik 42 erzeugt wird und der frequenzgleich mit dem ersten Takt 44 und dem zweiten Takt 50, gegenüber diesen aber gegebenenfalls phasenverschoben ist.

Das Ausgangssignal des Synchrondemodulators 32 wird über einen Tiefpass 54 geführt. Es ist dabei festzustellen, dass der Tiefpass 54 mit dem Synchrondemodulator 32 als Einheit gesehen wird. Im Folgenden wird daher vom Ausgangssignal des Synchrondemodulators 32 gesprochen, wobei damit das am Ausgang des Tiefpasses 54 anliegende Signal am Punkt 56 gemeint ist.

Um das in Fig. 2 dargestellte Sensorsystem zu initialisieren und damit auf die konkret vorhandenen Einbauverhältnisse abzustimmen, wird zunächst sichergestellt, dass sich kein Hindernis im Erfassungsbereich des Sensors 10 befindet.

Das Sensorsystem befindet sich darüber hinaus im Betrieb, die Steuerelektronik 42 erzeugt also den ersten Takt 44, so dass der Sensor 10 mit einem Sinussignal beaufschlagt wird.

An den nicht invertierenden Eingang 58 des Differenzverstärkers 48 wird dann mittels der Schaltung 34 ein Gegensignal angelegt, das den Eingang des Differenzverstärkers 48 in die Sättigung treibt. Das Signal am Ausgang des Differenzverstärkers 48 stellt dann nahezu ein Rechtecksignal dar. Hierzu kann das Auswertesignal am invertierenden Eingang des Differenzverstärkers 48 deaktiviert werden. Dies ist jedoch nicht zwingend erforderlich, da das Gegensignal am Eingang 58 des Differenzverstärkers 48 deutlich größer ist und den Operationsverstärker in die Sättigung treibt. Befindet sich der Operationsverstärker in der Sättigung, kann nun die Phasenlage des Gegensignals durch eine Phasenverschiebung des zweiten Takts 50 so lange geändert werden, bis sich am Ausgang des Synchrondemodulators, also am Punkt 56, eine Gleichspannung mit einem vordefinierten Wert einstellt. Dieser vordefinierte Wert kann aufgrund der Ausbildung des Sensorsystems nur entstehen, wenn der Synchrondemodulator 32 das Signal nicht in seinem Nulldurchgang, sondern um 90° hierzu verschoben abtastet. Der dritte Takt 52 entspricht bei dem eben beschriebenen Vorgang in Bezug auf die Frequenz dabei dem ersten Takt 44.

In einem zweiten Schritt wird nun die Phasenlage des Gegensignals am Eingang 58 des Differenzverstärkers 48 um 90° zum dritten Takt 52 verschoben. Dies erfolgt mittels der Steuerelektronik 42. Die Steuerelektronik 42 kann hierzu die Phasenlage des zweiten Takts 50 fest an den dritten Takt 52 koppeln.

Im nächsten Schritt wird nun der Einfluss des Gegensignals am Eingang 58 des Differenzverstärkers 48 abgeschaltet. Dies kann beispielsweise dadurch erfolgen, dass der Eingang 58 deaktiviert wird oder dass die Amplitude des Gegensignals auf null Volt gestellt wird. Auf den Differenzverstärker 48 wirkt damit lediglich das Auswertesignal an seinem Eingang 60. Der Abtastzeitpunkt des Synchrondemodulators 32 und damit der zweite Takt 50 werden nun der Phase so verschoben, bis sich am Punkt 56, also am Ausgang des Synchrondemodulators 32, erneut der vordefinierte Gleichspannungswert einstellt. Ist dies der Fall, befindet sich der Abtastzeitpunkt des Synchrondemodulators 32 an einem Punkt, der um 90° zum Nulldurchgang des Auswertesignals am Eingang 60 des Differenzverstärkers 48 liegt. Die Veränderung des Abtastzeitpunkts des Synchrondemodulators 32 erfolgt dabei durch eine Anpassung des dritten Takts 52 durch die Steuerelektronik 42. Ist der vordefinierte Wert am Punkt 56 erreicht, sind die Signale an den beiden Eingängen 58, 60 und der dritte Takt 52 des Synchrondemodulators 32 phasengleich.

In einem nächsten Schritt erfolgt nun ein Nullabgleich, indem die Amplitude des Gegensignals G am Eingang 58 des Differenzverstärkers 48 so lange erhöht wird, bis sich am Ausgang des Synchrondemodulators 32, also am Punkt 56, wieder der vordefinierte Wert ergibt.

Damit kann der Abgleichbetrieb abgeschlossen werden und es kann in einen Detektionsbetrieb übergegangen werden. In einem Detektionsbetrieb kann das Ausgangssignal des Synchrondemodulators, also das Signal am Punkt 56, für die Detektion eines Hindernisses verwendet werden. Alternativ kann eine Regelung des Ausgangssignals am Punkt 56 auf den Wert null oder einen vorbestimmten Wert vorgesehen werden, indem die Phasenlage oder die Amplitude des Gegensignals am Eingang 58 des Differenzverstärkers 48 verändert wird. Die Phasenlage bzw. die Amplitude des Gegensignals kann dann alternativ oder zusätzlich zum Detektieren eines Hindernisses herangezogen werden.

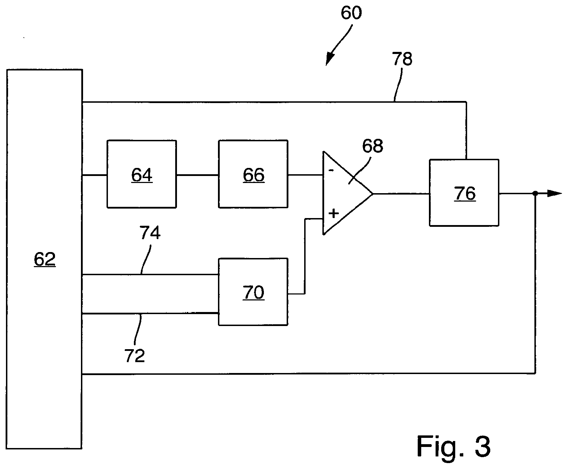

Fig. 3 zeigt schematisch ein erfindungsgemäßes Sensorsystem mit einer erfindungsgemäßen Schaltung gemäß einer dritten Ausführungsform. Das Sensorsystem 60 weist eine Steuerelektronik 62 auf, die u.a. für die Erzeugung von Taktsignalen und zur Energieversorgung vorgesehen ist. Ein erster Takt wird einem Ansteuerabschnitt 64 zugeführt, der ein Ansteuersignal mit einer ersten Frequenz erzeugt. Ein Sensor 66 wird dann mit dem Ansteuersignal beaufschlagt. Beispielsweise kann der Sensor 66 das Ansteuersignal in einen Messraum hinein senden. Der Sensor 66 liefert als Ausgang auch ein Messsignal, das dann, je nach vorhanden sein oder nicht vorhanden sein eines zu detektierenden Sachverhalts, gegenüber dem Ansteuersignal in typischer Weise verändert ist. Am Beispiel eines kapazitiven Sensors verändert sich das Messsignal gegenüber dem Ansteuersignal durch Vorhandensein einer Kapazität im Messraum, beispielsweise einer menschlichen Hand. Das Messsignal wird dann einem Operationsverstärker 68 zugeführt. Ein weiterer Eingang des Operationsverstärkers 68 wird von einem Abschnitt 70 zum Erzeugen eines Gegensignals mit dem Gegensignal beaufschlagt. Zum Erzeugen des Gegensignals erhält der Abschnitt 70 zum einen von der Steuerelektronik eine Taktsignal 72 sowie über eine Leitung 74 eine Energieversorgung. Mit dem Abschnitt 70 kann zumindest die Phase des Gegensignals verändert werden. Das Gegensignal ist dabei Frequenzgleich zum Ansteuersignal. Das Gegensignal und das Auswertesignal werden dann mittels des Operationsverstärkers 68 überlagert und einem Synchrondemodulator 76 zugeführt. Der Synchrondemodulator 76 weist einen nachgeschalteten Tiefpass auf, der in der Darstellung der Fig. 3 der Einfachheit halber nicht dargestellt ist. Ein Ausgangssignal des Synchrondemodulators 76 wird zu der Steuerelektronik 62 zurückgeführt und der Synchrondemodulator erhält einen Takt 78 von der Steuerelektronik 62. Die in Fig. 3 dargestellte Schaltung ist lediglich schematisch gezeigt, um das erfindungsgemäße Prinzip darstellen und erläutern zu können. Durch eine Veränderung der Phasenlage und/oder der Amplitude des Gegensignals, das mit dem Abschnitt 70 erzeugt wird, kann am Ausgang des Synchrondemodulator 76 ein vordefinierter Wert eingestellt werden und dadurch kann die Schaltung 60 in sehr einfacher Weise vor dem eigentlichen Messbeginn abgeglichen werden. Dadurch können in äußerst einfacher Weise unterschiedliche Einbauverhältnisse des Sensors 66 ausgeglichen werden.

## Patentansprüche

1. Schaltung zum Auswerten von Messsignalen wenigstens eines Sensors mit einer Steuerschaltung (18) und einer Auswerteelektronik (20), wobei mittels eines Ansteuerabschnitts (26) der Steuerschaltung (18) ein Ansteuersignal mit einer ersten Frequenz erzeugt wird, wobei der wenigstens eine Sensor mit dem Ansteuersignal beaufschlagt wird, wobei die Auswerteelektronik (20) zum Erzeugen eines Auswertesignals ausgehend von einem mit dem Sensor erzeugten Messsignal vorgesehen ist, wobei die Auswerteelektronik (20) Mittel (34) zum Erzeugen eines Gegensignals (G) mit der ersten Frequenz sowie veränderbarer Phasenlage und Mittel zum Überlagern des Gegensignals (G) und des Auswertesignals aufweist und wobei das sich aus dem Überlagern des Gegensignals und des Auswertesignals ergebende Signal einem Synchrondemodulator (32) der Auswerteelektronik (20) zugeführt wird, wobei die Schaltung so ausgebildet ist, dass in einem Abgleichbetrieb ein automatisches Abgleichen der Schaltung mittels Einstellen einer Phasenverschiebung des Gegensignals (G) in Abhängigkeit eines Ausgangssignals des Synchrondemodulators erfolgt, **dadurch gekennzeichnet, dass** in einem Abgleichbetrieb der Schaltung eine Phasenverschiebung des Gegensignals (G) und eines Takts des Synchrondemodulators (32) so eingestellt wird, dass das Auswertesignal, das Gegensignal (G) und der Takt des Synchrondemodulators (32) phasengleich sind.

2. Schaltung nach Anspruch 1, **dadurch gekennzeichnet, dass** die Mittel (34) zum Erzeugen des Gegensignals (G) zum Verändern einer Amplitude des Gegensignals (G) ausgebildet sind.

3. Schaltung nach Anspruch 1 oder 2, **dadurch gekennzeichnet, dass** die Mittel (34) zum Erzeugen des Gegensignals (G) in Abhängigkeit eines Ausgangssignals des Synchrondemodulators (32) arbeiten.

4. Schaltung nach wenigstens einem der vorstehenden Ansprüche, **dadurch gekennzeichnet, dass** eine Phasenverschiebung und/oder eine Amplitude des Gegensignals (G) ausgewertet wird.

5. Schaltung nach wenigstens einem der vorstehenden Ansprüche, **dadurch gekennzeichnet, dass** ein Ausgangssignal des Synchrondemodulators (32) ausgewertet wird.

6. Schaltung nach wenigstens einem der vorstehenden Ansprüche, **dadurch gekennzeichnet, dass** die Auswertelektronik (20) einen Regelkreis aufweist, wobei eine Phasenverschiebung des Gegensignals (G) zum Regeln eines Ausgangssignals des Synchrondemodulators (32) verwendet wird.

7. Verfahren zum Auswerten von Messsignalen, die von wenigstens einem Sensor erzeugt werden, mit einer Schaltung nach einem der vorstehenden Ansprüche, mit den Schritten:
Beaufschlagen des Sensors mit einem Ansteuersignal mit einer ersten Frequenz, Erzeugen eines Gegensignals mit der ersten Frequenz sowie veränderbarer Phasenlage, Erzeugen eines Auswertesignals ausgehend von einem mit dem Sensor erzeugten Messsignal, Überlagern des Auswertesignals und des Gegensignals und Zuführen des sich aus der Überlagerung ergebenden Signals zu einem Synchrondemodulator, wobei in einem Abgleichbetrieb ein automatisches Abgleichen der Schaltung mittels Einstellen einer Phasenverschiebung des Gegensignals (G) in Abhängigkeit eines Ausgangssignals des Synchrondemodulators erfolgt,
**dadurch gekennzeichnet, dass** in einem Abgleichbetrieb eine Phasenverschiebung des Gegensignals (G) und eines Takts des Synchrondemodulators (32) so eingestellt wird, dass das Auswertesignal, das Gegensignal (G) und der Takt des Synchrondemodulators (32) phasengleich sind.

8. Verfahren nach Anspruch 7, wobei in einem Abgleichbetrieb eine Amplitude des Gegensignals so eingestellt wird, dass das Ausgangssignal des Synchrondemodulators (32) einen Wert Null oder einen vordefinierten Wert aufweist.

9. Verfahren nach Anspruch 7 oder 8, wobei eine Auswertung einer Phasenverschiebung des Gegensignals (G) erfolgt.

10. Verfahren nach wenigstens einem der Ansprüche 7 bis 9, wobei eine Auswertung eines Ausgangssignals des Synchrondemodulators (32) erfolgt.

11. Verfahren nach wenigstens einem der Ansprüche 7 bis 10, wobei eine Regelung eines Ausgangsignals des Synchrondemodulators (32) auf einen Wert Null oder einen vordefinierten Wert vorgesehen ist.

12. Verfahren nach Anspruch 11, wobei als Stellgröße eine Phasenverschiebung und/oder eine Amplitude des Gegensignals (G) vorgesehen sind.

13. Sensorsystem zur kapazitiven Erfassung von Hindernissen, mit wenigstens einem kapazitiven Sensor und einer Schaltung zum Auswerten von Messsignalen des kapazitiven Sensors nach wenigstens einem der Ansprüche 1 bis 6.

## Claims

1. Circuit for evaluating measurement signals of at least one sensor with a control circuit (18) and an electronic evaluation unit (20), wherein a control signal having a first frequency is generated by means of a control section (26) of the control circuit (18), wherein the control signal is applied to the at least one sensor, wherein the electronic evaluation unit (20) is provided for generating an evaluation signal originating from a measurement signal generated with the sensor, wherein the electronic evaluation unit (20) has means (34) for generating an opposing signal (G) having the first frequency and a modifiable phase angle and means for superposing the opposing signal (G) and the evaluation signal, and wherein the signal resulting from the superposition of the opposing signal and the evaluation signal is fed to a synchronous demodulator (32) of the electronic evaluation unit (20), wherein the circuit is configured such that the circuit is balanced automatically in a balancing operation by adjusting a phase shift of the opposing signal (G) depending on an output signal of the synchronous demodulator,
**characterized in that**
in a balancing operation of the circuit a phase shift of the opposing signal (G) and a clock signal of the synchronous demodulator (32) are set in such a way that the evaluation signal, the opposing signal (G) and the clock of the synchronous demodulator (32) are in-phase.

2. Circuit according to claim 1, **characterized in that** the means (34) for generating the opposing signal (G) are designed to modify an amplitude of the opposing signal (G).

3. Circuit according to claim 1 or 2, **characterized in that** the means (34) for generating the opposing signal (G) operate depending on an output signal of the synchronous demodulator (32).

4. Circuit according to at least one of the preceding claims, **characterized in that** a phase shift and/or an amplitude of the opposing signal (G) is/are evaluated.

5. Circuit according to at least one of the preceding claims, **characterized in that** an output signal of the synchronous demodulator (32) is evaluated.

6. Circuit according to at least one of the preceding claims, **characterized in that** the electronic evaluation unit (20) has a control circuit, wherein a phase shift of the opposing signal (G) is used to adjust an output signal of the synchronous demodulator (32).

7. Method for evaluating measurement signals which are generated by at least one sensor, with a circuit according to any of the preceding claims, comprising the steps:
applying a control signal having a first frequency to the sensor, generating an opposing signal having the first frequency and a modifiable phase angle, generating an evaluation signal originating from a measurement signal generated with the sensor, superposing the evaluation signal and the opposing signal and feeding the signal resulting from the superposition to a synchronous demodulator, wherein the circuit is balanced automatically in a balancing operation by adjusting a phase shift of the opposing signal (G) depending on an output signal of the synchronous demodulator,
**characterized in that**
in a balancing operation a phase shift of the opposing signal (G) and a clock signal of the synchronous demodulator (32) are set in such a way that the evaluation signal, the opposing signal (G) and the clock of the synchronous demodulator (32) are in-phase.

8. Method according to claim 7, wherein an amplitude of the opposing signal is adjusted in a balancing operation in such a way that the output signal of the synchronous demodulator (32) has a value of zero or a predefined value.

9. Method according to claim 7 or 8, wherein a phase shift of the opposing signal (G) is evaluated.

10. Method according to at least one of claims 7 to 9, wherein an output signal of the synchronous demodulator (32) is evaluated.

11. Method according to at least one of claims 7 to 10, wherein control of an output signal of the synchronous demodulator (32) to a value of zero or a predefined value is provided.

12. Method according to claim 11, wherein a phase shift and/or an amplitude of the opposing signal (G) is/are provided as a setting parameter.

13. Sensor system for capacitively detecting obstacles with at least one capacitive sensor and a circuit for evaluating measurement signals of the capacitive sensor according to at least one of claims 1 to 6.

## Revendications

1. Circuit destiné à interpréter des signaux de mesure d'au moins un capteur, comprenant un circuit de commande (18) et une électronique d'interprétation (20), dans lequel un signal d'excitation ayant une première fréquence est généré au moyen d'une section d'excitation (26) du circuit de commande (18), dans lequel ledit au moins un capteur est alimenté avec le signal d'excitation, dans lequel l'électronique d'interprétation (20) est prévue pour générer un signal d'interprétation à partir d'un signal de mesure généré avec le capteur, dans lequel l'électronique d'interprétation (20) comporte des moyens (34) pour générer un signal opposé (G) ayant la première fréquence et une phase variable et des moyens pour superposer le signal opposé (G) et le signal d'interprétation, et dans lequel le signal résultant de la superposition du signal opposé et du signal d'interprétation est acheminé vers un démodulateur synchrone (32) de l'électronique d'interprétation (20), dans lequel le circuit est conçu de telle sorte que, dans un mode d'ajustement, le circuit est automatiquement ajusté au moyen du réglage d'un déphasage du signal opposé (G) en fonction d'un signal de sortie du démodulateur synchrone,
**caractérisé en ce que**,
dans un mode d'ajustement du circuit, un déphasage du signal opposé (G) et une horloge du démodulateur synchrone (32) sont réglés de telle sorte que le signal d'évaluation, le signal opposé (G) et l'horloge du démodulateur synchrone (32) soient en phase.

2. Circuit selon la revendication 1, **caractérisé en ce que** les moyens (34) pour générer le signal opposé (G) sont conçus pour faire varier une amplitude du signal opposé (G).

3. Circuit selon la revendication 1 ou 2, **caractérisé en ce que** les moyens (34) pour générer le signal opposé (G) fonctionnent en fonction d'un signal de sortie du démodulateur synchrone (32).

4. Circuit selon au moins l'une des revendications précédentes, **caractérisé en ce qu'**un déphasage et/ou une amplitude du signal opposé (G) est/sont interprété(s).

5. Circuit selon au moins une des revendications précédentes, **caractérisé en ce qu'**un signal de sortie du démodulateur synchrone (32) est interprété.

6. Circuit selon au moins une des revendications précédentes, **caractérisé en ce que** l'électronique d'interprétation (20) comporte une boucle de régulation, dans lequel un déphasage du signal opposé (G) est utilisé pour réguler un signal de sortie du démodulateur synchrone (32).

7. Procédé destiné à interpréter des signaux de mesure qui sont générés par au moins un capteur, comprenant un circuit selon l'une des revendications précédentes, comprenant les étapes consistant à:
alimenter le capteur avec un signal d'excitation ayant une première fréquence, générer un signal opposé ayant la première fréquence et une phase variable, générer un signal d'interprétation à partir d'un signal de mesure généré par le capteur, superposer le signal d'interprétation et le signal opposé et acheminer le signal résultant de cette superposition vers un démodulateur synchrone, dans lequel, dans un mode d'ajustement, un ajustement automatique du circuit est effectué par réglage d'un déphasage du signal opposé (G) en fonction d'un signal de sortie du démodulateur synchrone,
**caractérisé en ce que**,
dans un mode d'ajustement, un déphasage du signal opposé (G) et une horloge du démodulateur synchrone (32) sont réglés de telle sorte que le signal d'interprétation, le signal opposé (G) et l'horloge du démodulateur synchrone (32) soient en phase.

8. Procédé selon la revendication 7, dans lequel, dans un mode d'ajustement, une amplitude du signal opposé est réglée de telle sorte que le signal de sortie du démodulateur synchrone (32) ait une valeur égale à zéro ou une valeur prédéfinie.

9. Procédé selon la revendication 7 ou 8, dans lequel une interprétation d'un déphasage du signal opposé (G) est effectuée.

10. Procédé selon au moins l'une des revendications 7 à 9, dans lequel une interprétation d'un signal de sortie du démodulateur synchrone (32) est effectuée.

11. Procédé selon au moins l'une des revendications 7 à 10, dans lequel une régulation d'un signal de sortie du démodulateur synchrone (32) à une valeur égale à zéro ou à une valeur prédéfinie est prévue.

12. Procédé selon la revendication 11, dans lequel un déphasage et/ou une amplitude du signal opposé (G) est/sont prévu(s) en tant que grandeur de réglage.

13. Système de capteurs destiné à la détection capacitive d'obstacles, comprenant au moins un capteur capacitif et un circuit destiné à interpréter des signaux de mesure du capteur capacitif selon au moins l'une des revendications 1 à 6.
